# EUROPÄISCHE PATENTSCHRIFT

(11) **EP 2 126 993 B1**
(45) Veröffentlichungstag und Bekanntmachung des Hinweises auf die Patenterteilung: **26.11.2014**
(21) Anmeldenummer: 08709086.6
(22) Anmeldetag: 19.02.2008
(51) Int. Cl.: H01L 41/083, H01L 41/273

(54) **PIEZOSTAPEL UND VERFAHREN ZUM HERSTELLEN EINES PIEZOSTAPELS**
PIEZOELECTRIC STACK AND METHOD FOR PRODUCING A PIEZOELECTRIC STACK
EMPILEMENT PIÉZOÉLECTRIQUE ET PROCÉDÉ DE FABRICATION D'UN EMPILEMENT PIÉZOÉLECTRIQUE

(30) Priorität: 19.02.2007 DE 102007008120
(43) Veröffentlichungstag der Anmeldung: 02.12.2009
(73) Patentinhaber: Continental Automotive GmbH, 30165 Hannover (DE)
(72) Erfinder: HAMANN, Christoph, 93107 Thalmassing (DE); KASTL, Harald Johannes, 95686 Fichtelberg (DE)
(86) Internationale Anmeldenummer: PCT/EP2008/051964
(87) Internationale Veröffentlichungsnummer: WO 2008/101908

(56) Entgegenhaltungen:
- WO-A-2006/087871
- DE-A1- 10 307 825
- JP-A- 2001 102 646
- JP-A- 2005 285 817

## Beschreibung

Die Erfindung betrifft einen Piezostapel und ein Verfahren zum Herstellen eines Piezostapels.

Piezoelemente werden u.A. für Positionierelemente, Ultraschallwandler, Sensoren und in Tintenstrahldruckern verwendet. Die Funktion eines Piezoelements beruht auf der Deformation piezokeramischer Materialien, wie z.B. Blei-Zirkonat-Titanat, unter Einwirkung eines elektrischen Feldes. Wird an das Piezoelement eine elektrische Spannung angelegt, so dehnt sich dieses in senkrechter Richtung zum von der elektrischen Spannung erzeugten elektrischen Feld aus.

Vorteile von Piezoelementen sind u.A. deren relativ große Geschwindigkeit, deren relativ große Effektivität und, wenn als Piezoaktor verwendet, deren relativ kleiner Stellweg.

Soll jedoch mit dem Piezoaktor ein relativ großer Stellweg erreicht werden, dann wird für den Piezoaktor ein Piezostapel aus mehreren abwechselnd aufeinanderfolgenden piezoelektrischen Schichten und Innenelektrodenschichten verwendet.

Um durch seine Ausdehnung eventuell entstehende schädliche Risse im Piezostapel quer zu den Innenelektrodenschichten zu verhindern, sollte eine durch die Dehnung hervorgerufene mechanische Spannung innerhalb des Piezostapels unter einem für das piezokeramische Material unschädlichen Niveau bleiben. Dies kann z.B. erreicht werden, indem der Piezostapel in kürzere Abschnitte aufgeteilt wird.

Aus der DE 103 07 825 A1 sind durchgehende, nicht leitende keramische Sollbruchschichten in Piezostapeln bekannt. Aus der WO 2006/087871 A1 ist es bekannt, in den inaktiven Bereichen eines Piezostapels, d. h. in Bereichen, in denen sich keine Innenelektroden entgegengesetzter Polarität gegenüberliegen, Rissbildungsschichten vorzusehen. Diese Rissbildungsschichten weisen eine geringere Grenzflächenfestigkeit zu den benachbarten Keramikschichten auf als die Innenelektrodenschichten. Damit soll eine Rissbildung bevorzugt in den inaktiven Bereichen des Stapels auftreten um Risse in den aktiven Bereich zu verhindern.

Aufgabe der Erfindung ist es daher, einen Piezostapel anzugeben, bei dem einerseits die Rissbildung gezielt eingeleitet wird und der andererseits relativ betriebssicher ausgeführt ist.

Eine weitere Aufgabe der Erfindung ist es, ein Verfahren zum Herstellen eines solchen Piezostapels anzugeben.

Die Aufgabe der Erfindung wird gelöst durch einen Piezostapel, gemäß dem unabhängigen Anspruch 1. Ein erfindungsgemäßer Piezostapel weist abwechselnd aufeinanderfolgende piezoelektrische Schichten und Innenelektrodenschichten, die abwechselnd mit zwei an der Außenseite des Piezostapels angeordneten Außenelektroden elektrisch verbunden sind, und wenigstens eine Sicherheitsschicht, die anstelle einer der Innenelektrodenschichten zwischen zwei aufeinanderfolgenden piezoelektrischen Schichten angeordnet ist, auf, wobei die Sicherheitsschicht derart strukturiert ist, dass sie eine interne Unterbrechung aufweist, die derart ausgeführt ist, dass die Sicherheitsschicht keinen elektrischen Kontakt zwischen den beiden Außenelektroden bildet, wenn sie beide Außenelektroden kontaktiert und elektrisch leitfähig ist.

Die weitere Aufgabe der Erfindung wird gelöst durch ein Verfahren zum Herstellen eines Piezostapels, gemäß dem unabhängigen Verfahrensanspruch 8.

Der erfindungsgemäße Piezostapel umfasst die aufeinanderfolgenden piezoelektrischen Schichten, die Innenelektrodenschichten und die beiden Außenelektroden. Somit ist zwischen zwei aufeinanderfolgenden piezoelektrischen Schichten eine Innenelektrodenschicht angeordnet. Ferner sind die Innenelektrodenschichten abwechselnd mit einer der beiden Außenelektroden kontaktiert. Die Außenelektroden sind an den Außenseiten des Piezostapels, z.B. an jeweils zwei gegenüberliegenden Außenseiten, angeordnet.

Im Betrieb des Piezostapels wird an die beiden Außenelektroden eine elektrische Spannung angelegt, die demnach abwechselnd auch an den Innenelektrodenschichten anliegt, wodurch sich die zwischen zwei Innenelektrodenschichten liegende piezoelektrische Schicht ausdehnt.

Um eine Gefahr einer ungewollten Rissbildung innerhalb des erfindungsgemäßen Piezostapels zumindest zu verringern oder gar zu verhindern, weist der erfindungsgemäße Piezostapel die wenigstens eine Sicherheitsschicht auf, die anstelle einer der Innenelektrodenschichten zwischen zwei piezoelektrischen Schichten angeordnet ist.

Insbesondere kann der erfindungsgemäße Piezostapel genau eine Sicherheitsschicht oder mehrere Sicherheitsschichten, die jeweils eine der Innenelektrodenschichten ersetzen, aufweisen.

Die Sicherheitsschicht erstreckt sich im Wesentlichen über die gesamte Querschnittsfläche des Piezostapels, und ist in der Regel mit beiden Außenelektroden verbunden.

Um sicherzustellen, dass die beiden Außenelektroden durch die Sicherheitsschicht elektrisch nicht kurzgeschlossen werden, ist diese erfindungsgemäß derart strukturiert, dass sie wenigstens eine interne Unterbrechung aufweist, die einen elektrischen Kurzschluss der Außenelektroden verhindert, sollten die Sicherheitsschicht elektrisch leitfähig sein. Somit wird auch zuverlässig ein Kurzschluss beider Außenelektroden verhindert, wenn die Sicherheitsschicht zunächst aus einem elektrisch isolierenden Material hergestellt wurde, jedoch im Laufe der Zeit elektrisch leitfähig wird.

Die Sicherheitsschicht ist in der Mitte unterbrochen. Des Weiteren kann die Sicherheitsschicht derart ausgeführt sein, dass der erfindungsgemäße Piezostapel gezielt reißen kann. Ferner kann die wenigstens eine Unterbrechung an die mechanische Spannungsverteilung des erfindungsgemäßen Piezostapels angepasst werden.

Erfindungsgemäß ist die Unterbrechung innerhalb der Sicherheitsschicht als wenigsten ein Spalt ausgeführt. Dann weist die Sicherheitsschicht wenigstens zwei durch den Spalt getrennte Teilsicherheitsschichten auf, die demnach elektrisch voneinander isoliert sind. Ist nun eine der Teilsicherheitsschichten nur mit einer der Außenelektroden und die andere Teilsicherheitsschicht nur mit der anderen Außenelektrode verbunden, dann kann ein elektrischer Kurzschluss der beiden Außenelektroden zuverlässig verhindert werden. Wird die Sicherheitsschicht mit mehreren Spalten versehen, dann kann ein Kurzschluss der Außenelektroden auch dann verhindert werden, wenn einer der Spalte z.B. aus prozesstechnischen Gründen nicht ausreichend breit ausgeführt wurde.

Nach einer Ausführungsform des erfindungsgemäßen Piezostapels ist die Sicherheitsschicht aus einem elektrisch isolierenden Material gefertigt. Dies wird beispielsweise dadurch realisiert, dass die Sicherheitsschicht zunächst elektrisch leitfähig ist und durch Wegdiffundieren leitfähiger Anteile, z.B. während thermischer Prozesse bei der Herstellung des erfindungsgemäßen Piezostapels, elektrisch isolierend wird. Ein geeignetes Material für die Sicherheitsschicht ist beispielsweise Silberpalladium.

Nach einer Variante des erfindungsgemäßen Piezostapels ist die Festigkeit der Sicherheitsschicht kleiner als die Festigkeit der Innenelektrodenschichten. Die Festigkeit der Sicherheitsschicht ist beispielsweise kleiner als etwa 30MPa. Ausführungsbeispiele der Erfindung sind in den beigefügten schematischen Zeichnungen exemplarisch dargestellt. Es zeigen:
- Fig. 1: eine perspektivische Seitenansicht eines Piezostapels,
- Fig. 2: ein Flussdiagramm zur Veranschaulichung der Herstellung des Piezostapels,
- Fig. 3: einen Querschnitt des Piezostapels und
- Figs. 4, 5: Querschnitte weiterer Piezostapel.

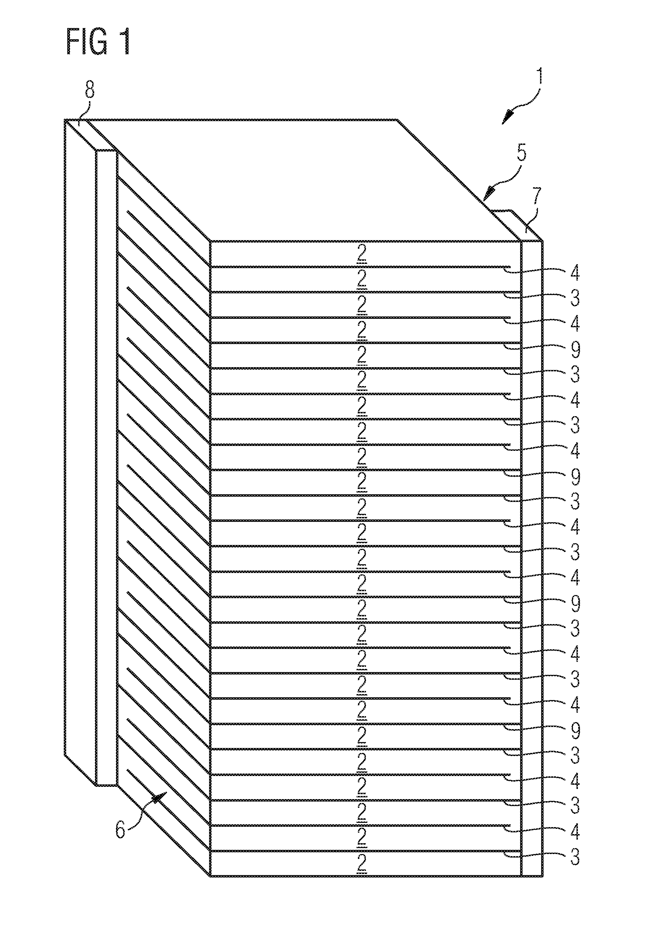

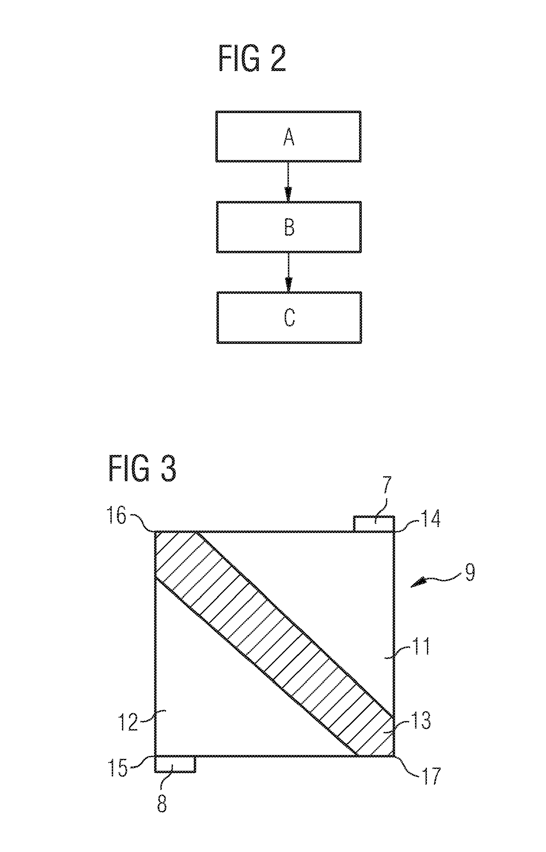

Die Fig. 1 zeigt einen im Falle des vorliegenden Ausführungsbeispiels quaderförmig ausgebildeten Piezostapel 1, die Fig. 2 zeigt ein Flussdiagramm zur Veranschaulichung der Herstellung des Piezostapels 1 und die Fig. 3 zeigt einen Querschnitt des Piezostapels 1.

Der Piezostapel 1 weist mehrere piezoelektrische Schichten 2 und mehrere dazwischen angeordnete schichtförmige Innenelektroden 3, 4 auf. Die piezoelektrischen Schichten 2 umfassen ein piezokeramisches Material, im Falle des vorliegenden Ausführungsbeispieles Blei-Zirkonat-Titanat, und bei den Innenelektroden 3, 4 handelt es sich im Falle des vorliegenden Ausführungsbeispiels um elektrisch leitfähige Metallschichten.

An im Falle des vorliegenden Ausführungsbeispiels gegenüberliegenden Außenseiten 5, 6 ist jeweils eine Außenelektrode 7, 8 angeordnet, die als Außenmetallisierungen längs der Außenseiten 5, 6 aufgetragen wurden. Damit die auf der Außenseite 5 angeordnete Außenelektrode 7 die Innenelektroden 3 kontaktiert, jedoch die Innenelektroden 4 nicht kontaktiert, sind im Falle des vorliegenden Ausführungsbeispiels die Innenelektroden 3 durchgehend bis an die Außenseite 5 herangeführt und die Innenelektroden 4 im Bereich der Außenelektrode 7 ausreichend in das Innere des Piezostapels 1 zurückversetzt.

Damit die auf der Außenseite 6 angeordnete Außenelektrode 8 die Innenelektroden 4 kontaktiert, jedoch die Innenelektroden 3 nicht kontaktiert, sind im Falle des vorliegenden Ausführungsbeispiels die Innenelektroden 4 durchgehend bis an die Außenseite 6 herangeführt und die Innenelektroden 3 im Bereich der Außenelektrode 8 ausreichend in das Innere des Piezostapels 1 zurückversetzt.

Somit kontaktiert die Außenelektrode 7 die Innenelektroden 3 und die Außenelektrode 8 die Innenelektroden 4, wodurch die Innenelektroden 3, 4 alternierend von den beiden Außenelektroden 7, 8 kontaktiert werden.

Der Piezostapel 1 weist ferner Sicherheitsschichten 9 auf, die anstelle von Innenelektroden 3, 4 zwischen zwei piezoelektrischen Schichten 2 angeordnet sind. Im Falle des vorliegenden Ausführungsbeispiels erstrecken sich die Sicherheitsschichten 9 über die gesamte Querschnittsfläche des Piezostapels 1 und kontaktieren in der Regel die beiden Außenelektroden 7, 8. Die Fig. 3 zeigt eine Draufsicht einer der Sicherheitsschichten 9, die wie dargestellt strukturiert ist.

Im Falle des vorliegenden Ausführungsbeispiels wurde der Piezostapel 1 durch die Prozessschritte Stapeln der einzelnen piezoelektrischen Schichten 2, Innenelektroden 3, 4 und der strukturierten Sicherheitsschichten 9, Schritt A des Flussdiagramms, und durch anschließendes Trennen, Entbindern und Schleifen, Schritt B, erzeugt. Anschließend wurden in einem Schritt C die Außenelektroden 7, 8 an die Außenseiten 5, 6 angeordnet.

Wie es aus der Fig. 3 ersichtlich ist, sind die einzelnen Sicherheitsschichten 9 derart strukturiert, dass sie im Falle des vorliegenden Ausführungsbeispiels jeweils zwei Teilsicherheitsschichten 11, 12 aufweisen, die von einem Spalt 13 getrennt sind. Im Falle des vorliegenden Ausführungsbeispiels sind die beiden Außenelektroden 7, 8 nahe zweier diagonal gegenüberliegender Kanten 14, 15 des Piezostapels 1 an den Außenseiten 5, 6 angeordnet und der Spalt 13 verläuft diagonal bezüglich der beiden weiteren Kanten 16, 17 des Piezostapels 1. Des Weiteren kontaktiert die Außenelektrode 7 die Teilsicherheitsschicht 11 und die Außenelektrode 8 die Teilsicherheitsschicht 12. Durch ihre Strukturierung, d.h. durch den Spalt 13 sind jedoch die beiden Teilsicherheitsschichten 11, 12 voneinander getrennt, sodass die Sicherheitsschicht 9 die beiden Außenelektroden 7, 8 auch dann nicht elektrisch verbindet, wenn die Sicherheitsschicht 9 elektrisch leitend sein sollte.

Im Falle des vorliegenden Ausführungsbeispiels sind die Sicherheitsschichten 9 z.B. aus Silberpalladium ausgebildet. Durch thermische Prozesse während der Herstellung des Piezostapels 1 verloren die Sicherheitsschichten 9 ihre Leitfähigkeiten durch ein Wegdiffundieren leitfähiger Anteile. Sollten die Sicherheitsschichten 9 trotzdem leitfähig, auch wenn nur relativ geringfügig leitfähig sein, dann werden trotzdem aufgrund des Spalts 13 die beiden Außenelektroden 7, 8 nicht durch die Sicherheitsschichten 9 elektrisch verbunden. Somit können insbesondere auch Piezostapel mit einer Querschnittsfläche kleiner als ca. 6,8 x 6,8 mm² betriebssicher hergestellt werden.

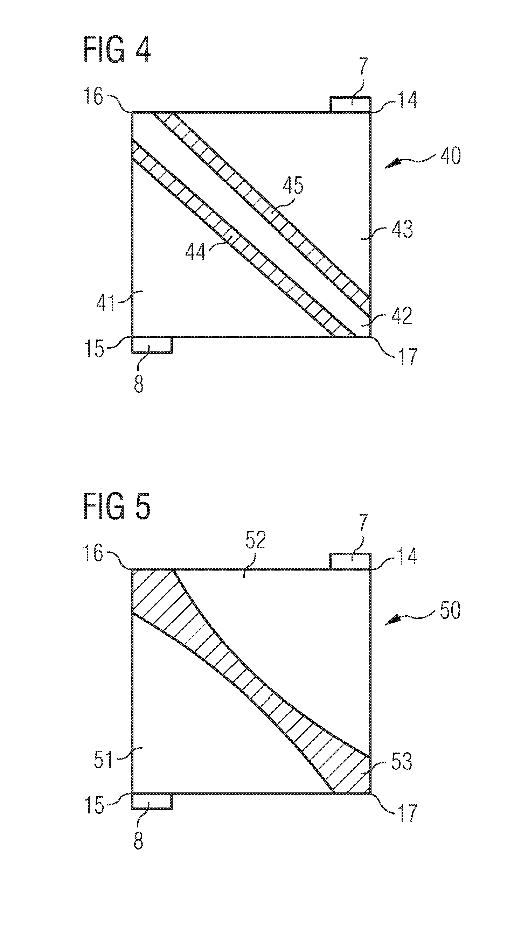

Die Fig. 4 zeigt eine alternative Ausführungsform einer Sicherheitsschicht 40, die anstelle der Sicherheitsschicht 9 für den Piezostapel 1 verwendet werden kann.

Im Gegensatz zu der in der Fig. 3 gezeigten Sicherheitsschicht 9 weist die in de Fig. 4 gezeigte Sicherheitsschicht 40 drei Teilsicherheitsschichten 41-43 und zwei Spalte 44, 45 auf. Die Teilsicherheitsschicht 41 ist dabei mit der Außenelektrode 8 verbunden und durch den Spalt 44 von der Teilsicherheitsschicht 42 getrennt. Die Teilssicherheitsschicht 42 ist durch den Spalt 45 von der Teilsicherheitsschicht 43 getrennt, die wiederum mit der Außenelektrode 7 verbunden ist.

Die in den Figuren 3, 4 dargestellten Spalte 13, 44, 45 sind in den dargestellten Ausführungsbeispielen steifenförmig ausgebildet. Dies ist nicht unbedingt nötig.

Die Fig. 5 zeigt eine alternative Ausführungsform einer Sicherheitsschicht 50, die anstelle der Sicherheitsschicht 9 für den Piezostapel 1 verwendet werden kann. Die Sicherheitsschicht 50 weist im Falle des vorliegenden Ausführungsbeispiels wie die Sicherheitsschicht 9 zwei Teilsicherheitsschichten 51, 52 auf, die durch einen diagonal verlaufenden Spalt 53 voneinander getrennt sind. Die Teilsicherheitsschicht 51 ist mit der Außenelektrode 8 und die Teilsicherheitsschicht 52 ist mit der Außenelektrode 7 verbunden.

Im Gegensatz zum Spalt 13 der in der Fig. 3 dargestellten Sicherheitsschicht 9 ist der Spalt 53 nicht streifenförmig ausgebildet, sondern verjüngt sich zu seiner Mitte. Dadurch ergibt sich eine verbesserte mechanische Spannungsverteilung im Piezostapel 1.

## Patentansprüche

1. Piezostapel aufweisend:
- abwechselnd aufeinanderfolgende piezoelektrische Schichten (2) und Innenelektrodenschichten (3, 4), die abwechselnd mit zwei an der Außenseite (5, 6) des Piezostapels (1) angeordneten Außenelektroden (7, 8) elektrisch verbunden sind, und
- wenigstens eine Sicherheitsschicht (9, 40, 50), die anstelle einer der Innenelektrodenschichten (3, 4) zwischen zwei aufeinanderfolgenden piezoelektrischen Schichten (2) angeordnet ist und sich im Wesentlichen über die gesamte Querschnittsfläche des Piezostapels (1) erstreckt,
**dadurch gekennzeichnet,**
**dass** die Sicherheitsschicht (9, 40, 50) derart strukturiert ist, dass sie eine interne Unterbrechung (13, 44, 45, 53) aufweist, die derart ausgeführt ist, dass die Sicherheitsschicht (9, 40, 50) keinen elektrischen Kontakt zwischen den beiden Außenelektroden (7, 8) bildet, wenn sie beide Außenelektroden (7, 8) kontaktiert und elektrisch leitfähig ist
- wobei die Unterbrechung in der Mitte der Sicherheitsschicht (9, 40, 50)angeordnet ist und als wenigstens ein Spalt (13, 44, 45, 53) ausgeführt ist, welcher die Sicherheitsschicht (9, 40, 50) in wenigstens zwei Teilsicherheitsschichten (11, 12, 41, 43, 51, 52) unterteilt.

2. Piezostapel nach Anspruch 1,
**dadurch gekennzeichnet,**
**dass** die Sicherheitsschicht (9, 40, 50) beide Außenelektroden (7, 8) kontaktiert.

3. Piezostapel nach einem der Ansprüche 1 bis 2,
**dadurch gekennzeichnet,**
**dass** die Außenelektroden (7, 8) nahe zweier diagonal gegenüberliegenden Kanten (14, 15) des Piezostapels angeordnet sind und der wenigstens eine Spalt (13, 44, 45, 53) diagonal bezüglich der weiteren Kanten (16, 17) verläuft.

4. Piezostapel nach einem der Ansprüche 1 bis 3,
**dadurch gekennzeichnet,**
**dass** die Sicherheitsschicht drei Teilsicherheitsschichten (41, 42, 43) und zwei Spalte (44, 45) aufweist.

5. Piezostapel nach Anspruch 3,
**dadurch gekennzeichnet,**
**dass** sich der die beiden Teilsicherheitsschichten (51, 52) trennende Spalt (53) zu seiner Mitte verjüngt.

6. Piezostapel nach einem der Ansprüche 1 bis 5,
**dadurch gekennzeichnet,**
**dass** die Sicherheitsschicht (9, 40, 50) aus einem elektrisch isolierenden Material gefertigt ist.

7. Piezostapel nach einem der Ansprüche 1 bis 6,
**dadurch gekennzeichnet,**
**dass** die Festigkeit der Sicherheitsschicht (9, 40, 50) kleiner als die Festigkeit der Innenelektrodenschichten (3, 4) ist, so dass der Piezostapel (1) gezielt reißen kann.

8. Verfahren zum Herstellen eines Piezostapels, der abwechselnd aufeinanderfolgende piezoelektrische Schichten (2) und Innenelektrodenschichten (3, 4), die abwechselnd mit zwei an der Außenseite (5, 6) des Piezostapels (1) angeordneten Außenelektroden (7, 8) elektrisch verbunden sind, und wenigstens eine Sicherheitsschicht (9, 40, 50) aufweist, die anstelle einer der Innenelektrodenschichten (3, 4) zwischen zwei aufeinanderfolgenden piezoelektrischen Schichten (2) angeordnet wird, und die sich im Wesentlichen über die gesamte Querschnittsfläche des Piezostapels (1) erstreckt,
**dadurch gekennzeichnet,**
**dass** die Sicherheitsschicht (9, 40, 50) derart strukturiert wird, dass sie eine interne Unterbrechung (13, 44, 45, 53) aufweist, die derart ausgeführt ist, dass die Sicherheitsschicht (9, 40, 50) keinen elektrischen Kontakt zwischen den beiden Außenelektroden (7, 8) bildet, wenn sie beide Außenelektroden (7, 8) kontaktiert und elektrisch leitfähig ist, wobei die Unterbrechung in der Mitte der Sicherheitsschicht (9, 40, 50) angeordnet und als wenigstens ein Spalt (13, 44, 45, 53) ausgeführt wird, welcher die Sicherheitsschicht (9, 40, 50) in wenigstens zwei Teilsicherheitsschichten (11, 12, 41, 43, 51, 52) unterteilt.

9. Verfahren nach Anspruch 8,
**dadurch gekennzeichnet,**
**dass** die Sicherheitsschicht (9, 40, 50) beide Außenelektroden (7, 8) kontaktiert.

10. Verfahren nach einem der Ansprüche 8 oder 9,
**dadurch gekennzeichnet,**
**dass** die Sicherheitsschicht (9, 40, 50) aus einem elektrisch isolierenden Material gefertigt wird.

11. Verfahren nach Anspruch 10,
**dadurch gekennzeichnet,**
**dass** die Sicherheitsschicht (9, 40, 50) zunächst elektrisch leitfähig ist und durch Wegdiffundieren leitfähiger Anteile durch thermische Prozesse während der Herstellung des Piezoaktors elektrisch isolierend wird.

12. Verfahren nach einem der Ansprüche 8 bis 11,
**dadurch gekennzeichnet,**
**dass** die Festigkeit der Sicherheitsschicht (9, 40, 50) kleiner als die Festigkeit der Innenelektrodenschichten (3, 4) ist.

13. Verfahren nach einem der Ansprüche 8 bis 12,
**dadurch gekennzeichnet,**
**dass** die Außenelektroden (7, 8) nahe zweier diagonal gegenüberliegenden Kanten (14, 15) des Piezostapels angeordnet sind und der wenigstens eine Spalt (13, 44, 45, 53) diagonal bezüglich der weiteren Kanten (16, 17) verläuft.

14. Verfahren nach einem der Ansprüche 8 bis 13,
**dadurch gekennzeichnet,**
**dass** die Sicherheitsschicht drei Teilsicherheitsschichten (41, 42, 43) und zwei Spalte (44, 45) aufweist.

15. Verfahren nach Anspruch 13,
**dadurch gekennzeichnet,**
**dass** sich der die beiden Teilsicherheitsschichten (51, 52) trennende Spalt (53) zu seiner Mitte verjüngt.

## Claims

1. Piezo stack having:
- alternately successive piezoelectric layers (2) and internal electrode layers (3, 4) which are alternately connected electrically to two external electrodes (7, 8) which are arranged on the outer side (5, 6) of the piezo stack (1), and
- at least one safety layer (9, 40, 50) which is arranged between two successive piezoelectric layers (2) instead of one of the internal electrode layers (3, 4) and extends essentially over the entire cross-sectional area of the piezo stack (1),
**characterized**
**in that** the safety layer (9, 40, 50) is structured in such a way that it has an internal interruption (13, 44, 45, 53) which is embodied in such a way that the safety layer (9, 40, 50) does not form an electrical contact between the two external electrodes (7, 8) if it makes contact with both external electrodes (7, 8) and is electrically conductive,
- wherein the interruption is arranged in the centre of the safety layer (9, 40, 50) and is embodied as at least one gap (13, 44, 45, 53) which divides the safety layer (9, 40, 50) into at least two partial safety layers (11, 12, 41, 43, 51, 52).

2. Piezo stack according to Claim 1,
**characterized**
**in that** the safety layer (9, 40, 50) makes contact with both external electrodes (7, 8).

3. Piezo stack according to either of Claims 1 and 2,
**characterized**
**in that** the external electrodes (7, 8) are arranged near to two edges (14, 15), lying diagonally opposite one another, of the piezo stack, and the at least one gap (13, 44, 45, 53) runs diagonally with respect to the other edges (16, 17).

4. Piezo stack according to one of Claims 1 to 3,
**characterized**
**in that** the safety layer has three partial safety layers (41, 42, 43) and two gaps (44, 45).

5. Piezo stack according to Claim 3,
**characterized**
**in that** the gap (53) which divides the two partial safety layers (51, 52) tapers towards its centre.

6. Piezo stack according to one of Claims 1 to 5,
**characterized**
**in that** the safety layer (9, 40, 50) is fabricated from an electrically insulating material.

7. Piezo stack according to one of Claims 1 to 6,
**characterized**
**in that** the safety layer (9, 40, 50) is less strong than the internal electrode layers (3, 4), with the result that the piezo stack (1) can tear in a targeted fashion.

8. A method for producing a piezo stack which has alternately successive piezoelectric layers (2) and internal electrode layers (3, 4) which are alternately connected electrically to two external electrodes (7, 8) which are arranged on the outer side (5, 6) of the piezo stack (1), and at least one safety layer (9, 40, 50) which is arranged between two successive piezoelectric layers (2) instead of one of the internal electrode layers (3, 4), and which extends essentially over the entire cross-sectional area of the piezo stack (1),
**characterized**
**in that** the safety layer (9, 40, 50) is structured in such a way that it has an internal interruption (13, 44, 45, 53) which is embodied in such a way that the safety layer (9, 40, 50) does not form an electrical contact between the two external electrodes (7, 8) if it makes contact with both external electrodes (7, 8) and is electrically conductive,
wherein the interruption is arranged in the centre of the safety layer (9, 40, 50) and is embodied as at least one gap (13, 44, 45, 53) which divides the safety layer (9, 40, 50) into at least two partial safety layers (11, 12, 41, 43, 51, 52).

9. Method according to Claim 8,
**characterized**
**in that** the safety layer (9, 40, 50) makes contact with both external electrodes (7, 8).

10. Method according to either of Claims 8 or 9,
**characterized**
**in that** the safety layer (9, 40, 50) is fabricated from an electrically insulating material.

11. Method according to Claim 10,
**characterized**
**in that** the safety layer (9, 40, 50) is electrically conductive at first and becomes electrically insulating through the diffusing away of conductive components by means of thermal processes during the manufacture of the piezo actuator.

12. Method according to one of Claims 8 to 11,
**characterized**
**in that** the safety layer (9, 40, 50) is less strong than the internal electrode layers (3, 4).

13. Method according to one of Claims 8 to 12,
**characterized**
**in that** the external electrodes (7, 8) are arranged near to two edges (14, 15), lying diagonally opposite one another, of the piezo stack, and the at least one gap (13, 44, 45, 53) runs diagonally with respect to the further edges (16, 17).

14. Method according to one of Claims 8 to 13,
**characterized**
**in that** the safety layer has three partial safety layers (41, 42, 43) and two gaps (44, 45).

15. Method according to Claim 13,
**characterized**
**in that** the gap (53) which separates the two partial safety layers (51, 52) tapers towards its centre.

## Revendications

1. Empilement piézoélectrique comportant :
- des couches piézoélectriques (2) et des couches d'électrodes intérieures (3, 4) successives alternées, qui sont reliées électriquement en alternance à deux électrodes extérieures (7, 8) disposées sur la face extérieure (5, 6) de l'empilement piézoélectrique (1), et
- au moins une couche de sécurité (9, 40, 50), qui est disposée en lieu et place de l'une des couches d'électrodes intérieures (3, 4) entre deux couches piézoélectriques (2) successives et qui s'étend sensiblement sur toute la surface de section transversale de l'empilement piézoélectrique (1),
**caractérisé en ce que**
la couche de sécurité (9, 40, 50) est structurée de telle sorte qu'elle comporte une interruption interne (13, 44, 45, 53) qui est réalisée de telle sorte que la couche de sécurité (9, 40, 50) ne forme pas de contact électrique entre les deux électrodes extérieures (7, 8) lorsqu'elle entre en contact avec les deux électrodes extérieures (7, 8) et lorsqu'elle est électroconductrice,
ladite interruption étant disposée au centre de la couche de sécurité (9, 40, 50) et étant réalisée sous la forme d'au moins une fente (13, 44, 45, 53) qui divise la couche de sécurité (9, 40, 50) en au moins deux couches de sécurité partielles (11, 12, 41, 43, 51, 52).

2. Empilement piézoélectrique selon la revendication 1, **caractérisé en ce que** la couche de sécurité (9, 40, 50) entre en contact avec les deux électrodes extérieures (7, 8).

3. Empilement piézoélectrique selon l'une quelconque des revendications 1 à 2, **caractérisé en ce que** les électrodes extérieures (7, 8) sont disposées à proximité de deux bords (14, 15) diagonalement opposés de l'empilement piézoélectrique, et ladite au moins une fente (13, 44, 45, 53) s'étend en diagonale par rapport aux autres bords (16, 17).

4. Empilement piézoélectrique selon l'une quelconque des revendications 1 à 3, **caractérisé en ce que** la couche de sécurité comporte trois couches de sécurité partielles (41, 42, 43) et deux fentes (44, 45).

5. Empilement piézoélectrique selon la revendication 3, **caractérisé en ce que** la fente (53) séparant les deux couches de sécurité partielles (51, 52) se rétrécit vers son centre.

6. Empilement piézoélectrique selon l'une quelconque des revendications 1 à 5, **caractérisé en ce que** la couche de sécurité (9, 40, 50) est réalisée dans un matériau électro-isolant.

7. Empilement piézoélectrique selon l'une quelconque des revendications 1 à 6, **caractérisé en ce que** la résistance de la couche de sécurité (9, 40, 50) est inférieure à la résistance des couches d'électrodes intérieures (3, 4), de telle sorte que l'empilement piézoélectrique (1) peut se déchirer de manière ciblée.

8. Procédé permettant de réaliser un empilement piézoélectrique qui comporte des couches piézoélectriques (2) et des couches d'électrodes intérieures (3, 4) successives alternées, qui sont reliées électriquement en alternance à deux électrodes extérieures (7, 8) disposées sur la face extérieure (5, 6) de l'empilement piézoélectrique (1), et au moins une couche de sécurité (9, 40, 50), qui est disposée en lieu et place de l'une des couches d'électrodes intérieures (3, 4) entre deux couches piézoélectriques (2) successives et qui s'étend sensiblement sur toute la surface de section transversale de l'empilement piézoélectrique (1),
**caractérisé en ce que**
l'on structure la couche de sécurité (9, 40, 50) de telle sorte qu'elle comporte une interruption interne (13, 44, 45, 53) qui est réalisée de telle sorte que la couche de sécurité (9, 40, 50) ne forme pas de contact électrique entre les deux électrodes extérieures (7, 8) lorsqu'elle entre en contact avec les deux électrodes extérieures (7, 8) et lorsqu'elle est électroconductrice, ladite interruption étant disposée au centre de la couche de sécurité (9, 40, 50) et étant réalisée sous la forme d'au moins une fente (13, 44, 45, 53) qui divise la couche de sécurité (9, 40, 50) en au moins deux couches de sécurité partielles (11, 12, 41, 43, 51, 52).

9. Procédé selon la revendication 8, **caractérisé en ce que** la couche de sécurité (9, 40, 50) entre en contact avec les deux électrodes extérieures (7, 8).

10. Procédé selon la revendication 8 ou 9, **caractérisé en ce que** la couche de sécurité (9, 40, 50) est réalisée dans un matériau électro-isolant.

11. Procédé selon la revendication 10, **caractérisé en ce que** la couche de sécurité (9, 40, 50) est d'abord électroconductrice et devient électro-isolante à la suite de la diffusion des fractions conductrices sous l'effet de processus thermiques pendant la fabrication de l'actionneur piézoélectrique.

12. Procédé selon l'une quelconque des revendications 8 à 11, **caractérisé en ce que** la résistance de la couche de sécurité (9, 40, 50) est inférieure à la résistance des couches d'électrodes intérieures (3, 4).

13. Procédé selon l'une quelconque des revendications 8 à 12, **caractérisé en ce que** les électrodes extérieures (7, 8) sont disposées à proximité de deux bords (14, 15) diagonalement opposés de l'empilement piézoélectrique, et ladite au moins une fente (13, 44, 45, 53) s'étend en diagonale par rapport aux autres bords (16, 17).

14. Procédé selon l'une quelconque des revendications 8 à 13, **caractérisé en ce que** la couche de sécurité comporte trois couches de sécurité partielles (41, 42, 43) et deux fentes (44, 45).

15. Procédé selon la revendication 13, **caractérisé en ce que** la fente (53) séparant les deux couches de sécurité partielles (51, 52) se rétrécit vers son centre.
